# EUROPEAN PATENT APPLICATION

(11) **EP 1 160 579 A1**
(43) Date of publication of application: **05.12.2001**
(21) Application number: 00111016.2
(22) Date of filing: 30.05.2000
(51) Int. Cl.: G01R 31/316

(54) **Containment device for burn-in boards, for testing integrated circuits and the like**

(71) Applicant: EMA Equipment Pte Ltd., SE 349574 Singapore (SG)
(72) Inventor: Mazzali, Carlo, 20052 MONZA (MI) (IT); Palella, Fortunato, 02100 Rieti (IT)
(74) Representative: Modiano, Guido, Dr.-Ing.

(57) **Abstract**

A containment device for burn-in boards, for testing integrated circuits and the like, comprising an upper plate (2) and a lower plate (3), at least one of the upper and lower plates being able to move with respect to the other plate, in order to provide an opening for inserting a burn-in board.

## Description

The present invention relates to a containment device for burn-in boards, for testing integrated circuits and the like.

It is known that a step termed as burn-in is performed during the production of integrated circuits; the purpose of this step is to eliminate the infant mortality of the devices by subjecting them to an intense thermal stress. The burn-in process and, of course, the systems required to implement it have evolved in various ways through the years so as to match increasingly sophisticated and complicated electronic devices.

For example, for memory devices it is essential to perform the burn-in process on 100% of production. These requirements, together with the development of devices which are increasingly smaller and complex, have made it indispensable to introduce new technological solutions and most of all to use a method which is automated so as to make it reliable and accordingly reduce production costs.

The burn-in method entails loading the devices (integrated circuits) on appropriately provided supporting boards which are then inserted in the burn-in systems, which subject the devices to high temperature and electrical stimulation. The new generation of burn-in systems simultaneously performs a test on the devices and identifies the defective ones.

It is known that integrated circuits are formed on a so-called lead frame which supports a plurality of integrated devices arranged side by side, substantially in an array-shaped configuration.

However, the burn-in method cannot be performed, with current devices, by using the integrated circuits in the state in which they are arranged on the lead frame, since it is necessary to remove each device from the lead frame and insert it in particular boards, known as burn-in boards, which are inserted in the burn-in systems and are designed to accommodate the integrated circuits and to perform, by means of appropriate connections, the electrical connection to the stimulation and testing modules of the system.

The burn-in process is currently performed on integrated circuits after they have been subjected to all the production steps. The integrated circuits inserted in the burn-in boards have the same final mechanical configuration that is typical of their use.

During the manufacturing steps that precede the burn-in step, the integrated circuits are in groups composed of more than one unit. A plurality of devices are in fact treated on a same lead frame. The lead frames accordingly contain a number of integrated circuits which varies according to their external package and can also be of the array type.

In this case, electrical contact with the individual integrated circuits is not possible by means of the conventional sockets used for contacting individual integrated-circuit devices.

The aim of the present invention is to provide a containment device for burn-in boards, particularly for integrated circuits and the like, which allows to perform a burn-in process directly on-line, after the normal steps for the production of integrated-circuit devices.

Within the scope of this aim, an object of the present invention is to provide a containment device for burn-in boards, particularly for integrated circuits and the like, in which the individual integrated-circuit devices can be subjected to bum-in cycles directly on their lead frame without being individually removed from it.

Another object of the present invention is to provide a containment device for burn-in boards, particularly for integrated circuits and the like, in which the lead frames and the corresponding burn-in boards can be easily replaced.

Another object of the present invention is to provide a containment device for burn-in boards, particularly for integrated circuits and the like, which is highly reliable, relatively easy to provide and at competitive costs.

These and other objects which will become better apparent hereinafter are achieved by a containment device for burn-in boards, particularly for testing integrated circuits and the like, characterized in that it comprises an upper plate and a lower plate, at least one of said upper and lower plates being able to move with respect to the other plate, in order to provide an opening for inserting a burn-in board.

Further characteristics and advantages of the invention will become better apparent from the description of a preferred but not exclusive embodiment of the device according to the invention, illustrated only by way of non-limitative example in the accompanying drawings, wherein:
Figure 1 is a transverse sectional view of the containment device according to the invention, shown in two different operating positions in the same figure;
Figure 2 is a plan view of the device shown in Figure 1;
Figure 3 is a plan view of a burn-in board which can be used in the device according to the present invention;
Figure 4 is a sectional view of a burn-in board which accommodates an integrated-circuit device;
Figure 5 is a sectional view of a detail of the burn-in board shown in Figure 4;
Figure 6 is a plan view of a metal plate used in the device according to the present invention; and
Figure 7 is a plan view of a sealing element used in the device according to the invention.

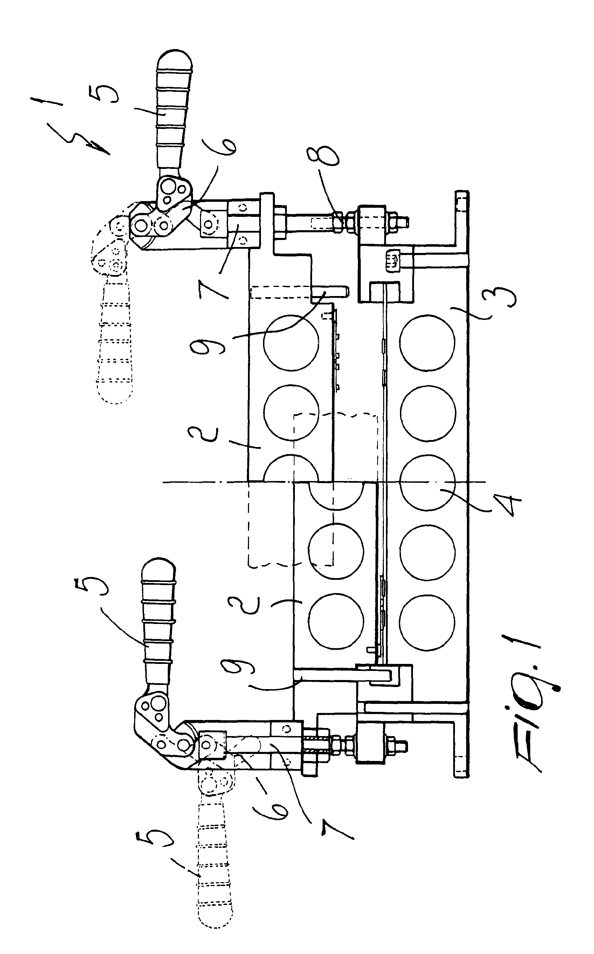

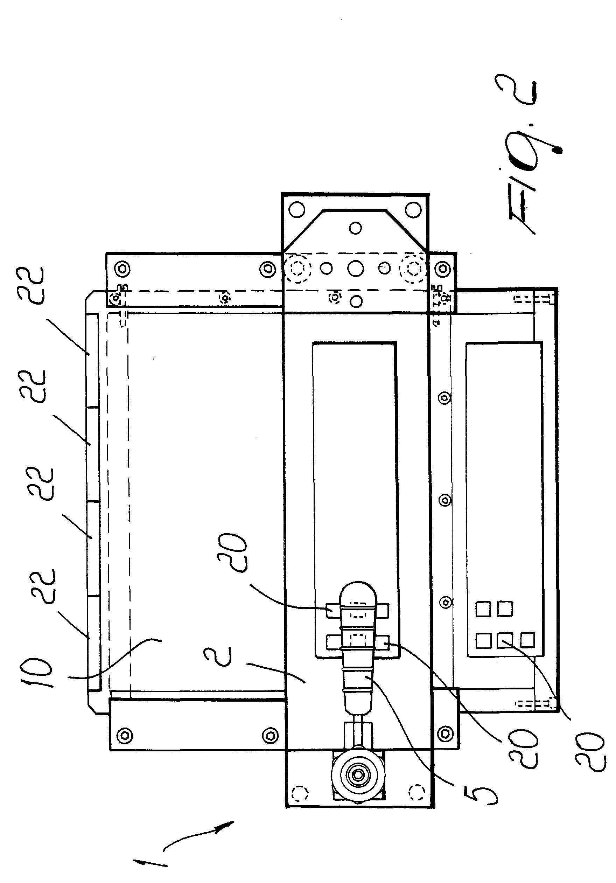

With reference to the above figures, and particularly at first to Figures 1 and 2, the device according to the invention, generally designated by the reference numeral 1, comprises an upper plate 2 and a lower plate 3; at least one of the plates 2 and 3 can move with respect to the other. Preferably, the movable plate is the plate 2, which is meant, by means of a suitable opening mechanism, to rise with respect to the lower plate 3.

Air flow holes 4 are provided, since the device according to the invention is placed, in one embodiment, in an oven in order to subject the integrated-circuit device accommodated therein to high temperatures.

In another embodiment, the holes 4 are not provided because the upper plate and the lower plate have an internal channel which allows to perform independent heating of the two plates, therefore without the need to place the device 1 in a suitable oven.

The mechanism for closing the plate 2 on the plate 3 conveniently comprises lever means 5 which are arranged at two facing sides of the plates 2 and 3 and allow, by virtue of a toggle lever system 6, to actuate a piston 7 which enters a guiding element 8 which is rigidly coupled to the lower plate 3.

The two levers 5 are rigidly coupled to the upper plate 2.

Additional guiding elements 9 are provided for optimum closure of the upper plate 2 on the lower plate 3 after interposing between the plates a printed circuit board, designated by the reference numeral 10, on which there is a lead frame which contains the devices to be subjected to burn-in cycles.

The upper plate internally accommodates a frame 15 which is preferably made of metal, with a corresponding protective mask 16, for example made of silicone rubber, which by means of a controlled pressure allows a perfect coupling which is extremely precise and rigid but at the same time sufficiently delicate with the devices. The pressure applied by the upper plate 2 and therefore by the rubber mask 16 allows perfect contact between the individual devices provided on the lead frame and the printed circuit board 10 that constitutes the burn-in board.

The rubber mask 16 is provided with suitable protruding areas, made of silicon rubber 17, which directly contact the devices arranged on the lead frame.

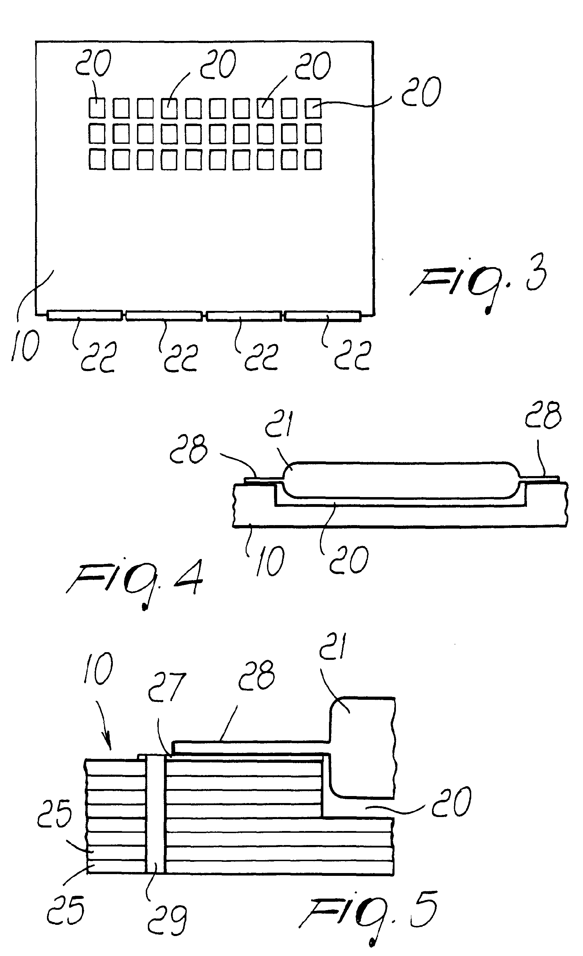

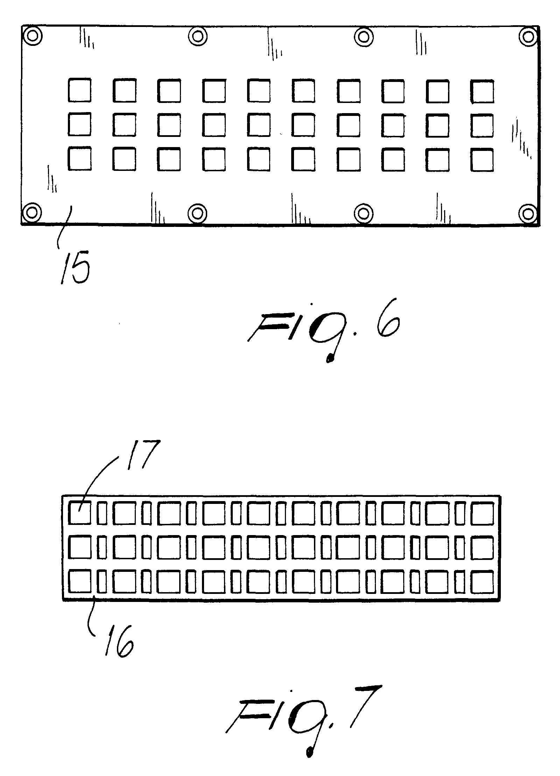

Figure 3 is a view of a printed circuit board 10 which constitutes the burn-in board and in which there are seats 20 for the integrated-circuit devices to be subjected to a burn-in cycle, designated by the reference numeral 21 in Figure 4.

The printed circuit board 20 is conveniently provided with at least one connector 22 arranged at at least one of its faces for connection to power supply and stimulation means for the integrated-circuit devices to be tested.

Figure 2 is a sectional view of the insertion of the integrated-circuit devices 21 in the corresponding seat 20 of the printed circuit board 10.

The integrated-circuit devices 21 can be arranged as shown in Figure 2, in which the printed circuit board portion 10 arranged below the device 21 has connecting tracks which pass through it.

Another embodiment of the printed circuit board eliminates the portion of board 10 below the integrated-circuit device 21.

Figure 3 is a detailed view of the printed circuit board 10, which is conveniently constituted by a plurality of mutually superimposed layers, each designated by the reference numeral 25, and a metallic plate or pad 27 is conveniently made of gold is arranged below the pins 28 of the integrated-circuit device 21 accommodated in the seat 20 of the printed circuit board 10.

A plated through hole 29 runs through the thickness of all the layers 25, so as to provide electrical connection between the pins of the integrated-circuit device and the tracks of the printed circuit board.

The presence of a plurality of layers 25 is due to the fact that the pins of the integrated-circuit device are very close to each other and therefore conventional electrical contacting on a single plane would be difficult.

Figure 2 illustrates the insertion of the printed circuit board 10 between the upper plate 2 and the lower plate 3 and shows the two possible positions of the board 10, i.e., one in which the portion bearing the integrated-circuit devices lies below the upper plate 2, and one in which the same portion is extracted from the plate 2 after said plate has been lifted with respect to the lower plate 3.

The operation of the device according to the invention is as follows.

Owing to the need to provide a burn-in cycle for integrated-circuit devices, the device according to the invention is placed on-line, i.e., the integrated-circuit devices, after the last production step, are transferred directly into the device while they are arranged on the respective lead frames. More particularly, the integrated-circuit devices arranged on the lead frames are accommodated on the printed circuit board 10, at the respective seats 20, and the board is inserted between the upper plate 2 and the lower plate 3 of the device 1.

The board 10 is inserted by lifting the upper plate 2 with respect to the lower plate 3.

The subsequent closure of the upper plate 2 on the lower plate 3, with the printed circuit board 10 interposed between them, allows the rubber mask 16 arranged on the metal plate 15 to make contact with the respective integrated-circuit devices 21 so as to accordingly provide electrical contact between the pins of the devices and the respective plates or pads 27 arranged on the printed circuit board 10.

Once the device burn-in cycle has been performed, the printed circuit board 10 is again extracted from the upper plate 2 and the lower plate 3, and the devices with the corresponding lead frame are removed from the printed circuit board, which is ready to be loaded with a new lead frame.

In the case of different lead frames, a different type of metal plate 15 and rubber mask 16, which can be easily removed from the upper plate 2, is used.

In practice it has been found that the device according to the invention fully achieves the intended aim, since it allows to subject integrated-circuit devices to a burn-in cycle without having to necessarily remove them from the respective lead frames; in particular, the burn-in cycles can be performed online, i.e., directly downstream of the last station for producing the integrated-circuit devices.

The device thus conceived is susceptible of numerous modifications and variations, all of which are within the scope of the inventive concept; all the details may furthermore be replaced with other technically equivalent elements.

In practice, the materials used, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A containment device for burn-in boards, for testing integrated circuits and the like, **characterized in that** it comprises an upper plate and a lower plate, at least one of said upper and lower plates being able to move with respect to the other plate, in order to provide an opening for inserting a burn-in board.

2. The device according to claim 1, **characterized in that** said upper plate is movable with respect to said lower plate, lever means being provided for lifting said upper plate.

3. The device according to claim 2, **characterized in that** said lever means are rigidly coupled to said upper plate and comprise a lever which is connected to a toggle which is in turn connected to a piston which is suitable to slidingly engage with a vertical guiding element provided on said lower plate.

4. The device according to one or more of the preceding claims, **characterized in that** said upper plate internally accommodates a metallic plate on which there is a rubber mask for contacting said burn-in board inserted between said upper plate and said lower plate.

5. The device according to one or more of the preceding claims, **characterized in that** said upper plate comprises additional guiding elements which are adapted to engage in seats which are rigidly coupled to said lower plate.

6. The device according to one or more of the preceding claims, **characterized in that** said metal plate accommodated inside said upper plate is meant to match a lead frame on which integrated-circuit devices to be subjected to burn-in cycles are arranged, said lead frame being meant to be arranged in turn on said burn-in board.

7. The device according to one or more of the preceding claims, **characterized in that** said upper plate and said lower plate are provided with air passage holes.

8. The device according to one or more of the preceding claims, **characterized in that** said upper plate and said lower plate are provided with internal channels for heating said plates.

9. The device according to one or more of the preceding claims, **characterized in that** said burn-in board is a multilayer printed circuit board.

10. The device according to one or more of the preceding claims, **characterized in that** said printed circuit board has a connecting pad which is meant to make contact with pins of said integrated-circuit devices which are meant to be accommodated in said board.

11. The device according to one or more of the preceding claims, **characterized in that** said printed circuit board has seats for said integrated-circuit devices arranged on said lead frame.

12. The device according to one or more of the preceding claims, **characterized in that** said printed circuit board has, for each seat for an integrated-circuit device, at least one plated through hole which passes through said plurality of layers that constitute said printed circuit board and ends at said contact pad.

13. The device according to one or more of the preceding claims, **characterized in that** said printed circuit board is provided with at least one connector which is arranged at at least one of its faces, proximate to one of the edges of said board.

14. A burn-in board, **characterized in that** it comprises a plurality of superimposed printed circuit layers and a plurality of seats formed in the upper layer of said plurality of printed circuit layers in order to accommodate a matching number of integrated circuit devices to be subjected to burn-in cycles.

15. The board according to claim 14, **characterized in that** it comprises, at said seats, contact pads which are meant to provide an electrical contact with pins of said integrated-circuit devices.

16. The board according to claim 14, **characterized in that** it provides, at said contact pads, plated through holes which pass through said plurality of layers that constitute said burn-in board.
